(19) Europäisches Patentamt

European Patent Office

Office européen des brevets

(11) **EP 0 738 045 B1**

(12) **EUROPÄISCHE PATENTSCHRIFT**

(45) Veröffentlichungstag und Bekanntmachung des Hinweises auf die Patenterteilung:
**04.10.2001 Patentblatt 2001/40**

(51) Int Cl.7: **H03M 1/18**
// H03M1/46

(21) Anmeldenummer: **96105426.9**

(22) Anmeldetag: **03.04.1996**

(54) **Analog-Digital-Umsetzer**

Analog-to-digital converter

Convertisseur analogique-numérique

(84) Benannte Vertragsstaaten:
**DE FR GB IT**

(30) Priorität: **11.04.1995 DE 19513796**

(43) Veröffentlichungstag der Anmeldung:
**16.10.1996 Patentblatt 1996/42**

(73) Patentinhaber: **Infineon Technologies AG**
**81669 München (DE)**

(72) Erfinder: **Kuttner, Franz, Dipl.-Ing.**
**9524 St. Ulrich (AT)**

(74) Vertreter: **Zedlitz, Peter, Dipl.-Inf. et al**
**Patentanwalt,**
**Postfach 22 13 17**
**80503 München (DE)**

(56) Entgegenhaltungen:
**EP-A- 0 064 147**       **EP-A- 0 078 608**
**US-A- 4 641 130**

## Beschreibung

Die Erfindung betrifft einen Analog-Digital-Umsetzer nach dem Prinzip der sukzessiven Approximation mit einem Kapazitätsnetzwerk.

Derartige Analog-Digital-Umsetzer sind beispielsweise aus der US-Patentschrift 4 399 426 und der US-Patentschrift 4 451 821 bekannt. Analog-Digital-Umsetzer mit Kapazitätsnetzwerk werden häufig dann eingesetzt, wenn weder der Analogeingang noch die Referenzspannungsquellen durch einen statischen Strom belastet werden sollen. Darüber hinaus bildet das Kapazitätsnetzwerk bereits eine Speicherkapazität, weswegen auf eine dem Analog-Digital-Umsetzer vorgeschaltete Sample- and-Hold-Schaltung verzichtet werden kann.

Während der Übernahmephase wird die zu messende analoge Eingangsspannung an die Kondensatoren gelegt. Während dieser Zeit wird die Spannung an den Eingängen des offsetkompensierten Komparators gespeichert. In der Konvertierungsphase wird durch wechselndes Anlegen zweier Referenzspannungen die Ladung am Kapazitätsnetzwerk so lange umverteilt, bis die Spannung an den Eingängen des Komparators, abgesehen vom Quantisierungsfehler, gleich der Spannung während der Übernahmephase ist. Die Stellung der Referenzschalter entspricht dann dem digitalisierten Wert der analogen Eingangsspannung.

Ein Nachteil dieser Umsetzer ist allerdings, daß der Eingangsspannungsbereich direkt mit den Referenzspannungen gekoppelt ist. Bei einer unteren Referenzspannung von a Volt und einer oberen Referenzspannung von b Volt wird beispielsweise eine Eingangsspannung von a Volt in den digital codierten Wert Null und die Spannung von b Volt in den maximal codierbaren digitalen Wert, der durch die Stellenzahl des digitalen Wertes vorgegeben ist, umgesetzt.

Will man beispielsweise bei den Referenzspannungen mit a Volt und b Volt eine Spannung messen, die zwischen a Volt und 2 x b Volt liegen kann, dann muß die zu messende Eingangsspannung erst durch einen Spannungsteiler auf den passenden Spannungsbereich gebracht werden. Mit einem ohmschen Spannungsteiler verliert jedoch der Umsetzer seine Eigenschaft, daß zu messende Eingangsspannungen nicht ohmisch zu belasten.

Aufgabe der Erfindung ist es, einen Analog-Digital-Umsetzer anzugeben, der einerseits eine kapazitive Eingangsimpedanz und andererseits einen durch die Referenzspannungen nicht festgelegten Eingangsspannungsbereich aufweist.

Die Erfindung wird durch einen Analog-Digital-Umsetzer gemäß Patentanspruch 1 gelöst. Weiterbildungen des Erfindungsgedankens sind Gegenstand von Unteransprüchen.

Die Erfindung wird nachfolgend anhand der in den Figuren der Zeichnung dargestellten Ausführungsbeispiele näher erläutert. Es zeigt:

| | |
|---|---|
| Figur 1 | ein erstes Ausführungsbeispiel eines erfindungsgemäßen Analog-Digital-Umsetzers in einem Schaltbild, |
| Figur 2 | das Verhältnis von Eingangsspannungsbereich zu Referenzspannungsbereich bei dem Analog-Digital-Umsetzer nach Figur 1 in einem Diagramm, |
| Figur 3 | ein zweites Ausführungsbeispiel eines erfindungsgemäßen Analog-Digital-Umsetzers in einem Schaltbild, |
| Figur 4 | das Verhältnis von Eingangsspannungsbereich zu Referenzspannungsbereich bei dem Analog-Digital-Umsetzer nach Figur 3 in einem Diagramm, |
| Figur 5 | ein drittes Ausführungsbeispiel eines erfindungsgemäßen Analog-Digital-Umsetzers in einem Schaltbild, |
| Figur 6 | das Verhältnis von Eingangsspannungsbereich zu Referenzspannungsbereich bei dem Analog-Digital-Umsetzer nach Figur 5 in einem Diagramm, |
| Figur 7 | ein viertes Ausführungsbeispiel eines erfindungsgemäßen Analog-Digital-Umsetzers in einem Schaltbild, |
| Figur 8 | bis Figur 12 jeweils das Verhältnis von Eingangsspannungsbereich zu Referenzspannungsbereich bei dem Analog-Digital-Umsetzer nach Figur 7 für verschiedene Schaltvarianten in einem Diagramm, |
| Figur 13 | ein fünftes Ausführungsbeispiel eines erfindungsgemäßen Analog-Digital-Umsetzers in einem Schaltbild und |
| Figur 14 | ein sechstes Ausführungsbeispiel eines erfindungsgemäßen Analog-Digital-Umsetzer in einem Schaltbild. |

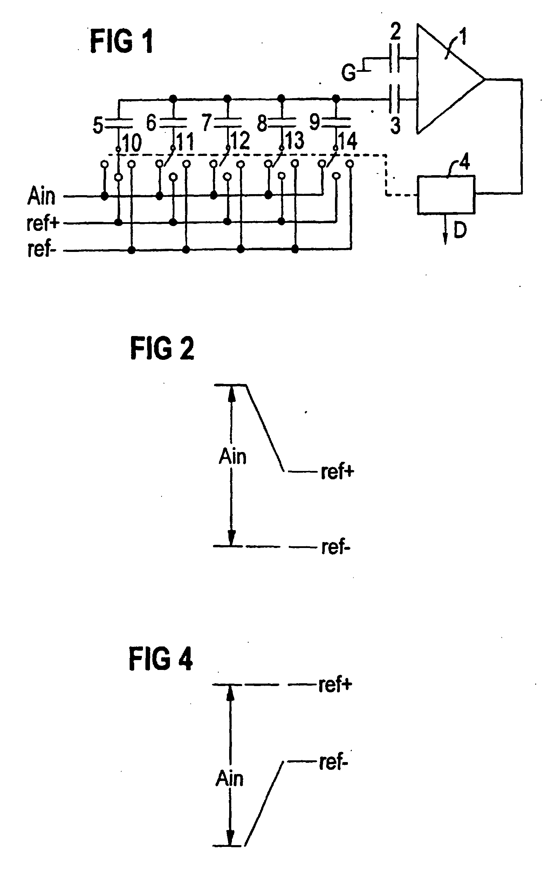

Den Analog-Digital-Umsetzern der Figuren 1, 3, 5, 7, 13 und 14 ist gemeinsam, daß ein Eingang -beispielsweise der nichtinvertierende Eingang- eines Komparators 1 über einen Kondensator 2 mit einem Bezugspotential G verbunden ist. Der andere -beispielsweise invertierende- Eingang ist über ein Koppelelement, beispielsweise eine Drahtverbindung oder einen Kondensator, mit einem Knotenpunkt cx gekoppelt. Vorliegend ist als Koppelelement ein Kondensator 3 vorgesehen. An den Knotenpunkt cx sind zudem jeweils die einen Anschlüsse mindestens von n=5 weiteren Kondensatoren 5 bis 9 angeschlossen, deren jeweils anderer Anschluß mittels jeweils eines Umschalters 10 bis 14 entweder auf ein Eingangspotential Ain oder auf ein Referenzpotential ref+ oder ein Referenzpotential ref- aufschaltbar ist, wobei n-1 die Wortbreite des Umsetzers ist. Die Umschalter 10 bis 14 werden durch eine Kontrolleinrichtung 4 gesteuert, die mit dem Ausgang des Komparators 1 verbunden ist und die ein digitales Ausgangssignal D abgibt.

Während einer Übernahmephase wird dabei durch die Kontrolleinrichtung 4 erfindungsgemäß zumindest ein Teil der Kondensatoren 5 bis 9 auf das Eingangspotential Ain und der verbleibende Teil entweder auf das Referenzpotential ref+ oder das Referenzpotential ref- aufgeschaltet. Während einer der Übernahmephase nachfolgenden Konvertierungsphase wird durch wechselndes Anlegen der Referenzspannungen ref+ bzw. ref- an zumindest einen Teil der Kondensatoren 5 bis 9 die Ladung so lange umverteilt, bis das Potential am Knoten cx bis auf den Quantisierungsfehler wieder dem Potential während der Übernahmephase entspricht. Ist dies der Fall, so wechselt der Komparator 1 sein Ausgangssignal und signalisiert damit der Kontrolleinrichtung 4, daß dieser Zustand erreicht worden ist. Die Kontrolleinrichtung 4 beendet daraufhin die Variation der Schalterstellungen der Schalter 10 bis 14 und gibt ein der letzten Schalterstellung entsprechendes digitales Signal D aus. Die Variation der Schalterstellungen während der Konvertierungsphase kann beispielsweise mittels eines Zählers realisiert werden, der von einem bestimmten Startwert inkrementiert oder dekrementiert wird, wobei einem bestimmten Zählerwert eine bestimmte Schalterstellung zugeordnet ist. Nachdem das entsprechende digitale Signal D ausgegeben worden ist, leitet die Kontrolleinrichtung 4 erneut eine Übernahmephase ein. Das digitale Signal D kann dabei seinen bisherigen Wert beispielsweise so lange halten, bis durch die darauffolgende Konvertierungsphase ein neuer Wert ermittelt worden ist.

Bei dem Ausführungsbeispiel nach Figur erfolgt die Steuerung der Umschalter 10 bis 14 durch die Kontrolleinrichtung 4 derart, daß während der Übernahmephase der Kondensator 5 auf das Referenzpotential ref- und die Kondensatoren 6 bis 9 auf das Eingangspotential Ain aufgeschaltet sind. In diesem Fall wird -wie in Figur 2 gezeigt- der zulässige Bereich des Eingangspotentials Ain einerseits über das Referenzpotentials ref+ hinaus erweitert. Andererseits bleibt der Bereich durch das Referenzpotential ref- begrenzt.

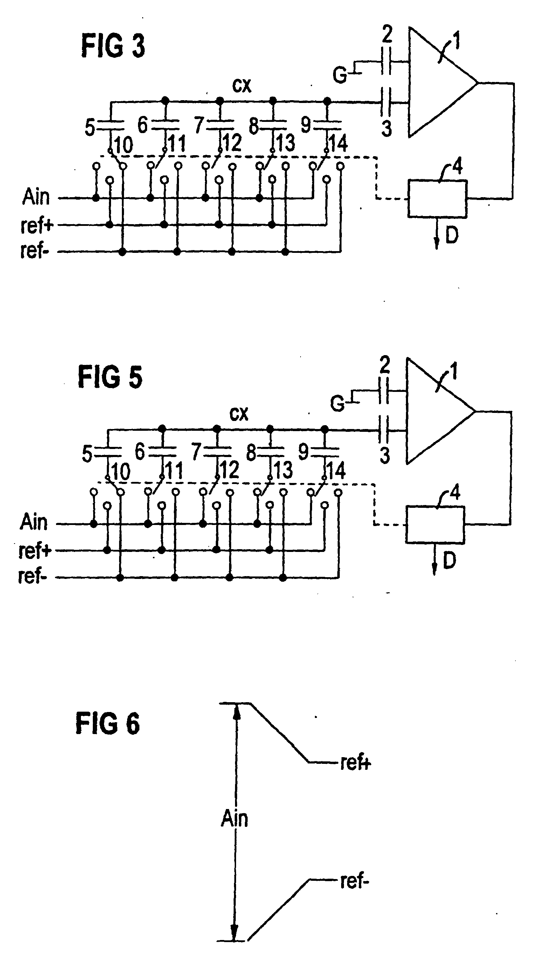

In gleicher Weise läßt sich -wie in Figur 4 gezeigt- der zulässige Bereich des Eingangspotentials Ain über das Referenzpotential ref- hinaus erweitern, in dem gemäß Figur 3 der Kondensator 5 während der Übernahmephase an das Referenzpotential ref+ gelegt wird, während die Kondensatoren 6 bis 9 auf das Eingangspotential Ain aufgeschaltet sind. In diesem Fall erfolgt aber wiederum nur einerseits eine Erweiterung des zulässigen Bereichs des Eingangspotentials Ain, während andererseits der Bereich weiterhin durch das jeweils andere Referenzpotential, in diesem Fall das Referenzpotential ref+, begrenzt wird.

Um nun eine Bereichserweiterung über beide Referenzpotentiale ref+, ref- hinaus zu erzielen, wird gemäß Figur 5 während der Übernahmephase der Kondensator 5 mit dem Referenzpotential ref- und der Kondensator 6 mit dem Referenzpotential ref+ beaufschlagt. Die Kondensatoren 7 bis 9 werden dagegen auf das Eingangspotential Ain aufgeschaltet. Die Bereichserweiterung über jeweils die Referenzpotentiale ref+ und ref- hinaus ist in Figur 6 dargestellt.

Die Bereichserweiterung läßt sich formal wie folgt darlegen:

$$\text{Ain+} = (\text{ref+}) \cdot (\text{Ca}/\text{Cr+})$$

und

$$\text{Ain-} = (\text{ref-}) \cdot (\text{Ca}/\text{Cr-}).$$

Dabei werden die Bereichsgrenzen des Eingangspotentials Ain mit Ain+ und Ain- bezeichnet und die auf das Eingangspotential Ain aufgeschalteten Kapazitäten mit Ca und die an das jeweilige Referenzpotential ref-, ref+ mit Cr-, Cr+. Wird beispielsweise bei einer Referenzspannung ref+=2,5 Volt und ref-=0 Volt die Gesamtkapazität der an das Eingangspotential Ain angelegten Kondensatoren gleich der Gesamtkapazität der an das Referenzpotential ref+ angeschlossenen Kondensatoren gewählt, so ergibt sich ein Eingangsbereich von 0 Volt bis 5 Volt.

Bei den drei bisher betrachteten Fällen sind während der Konvertierungsphase sämtliche Kondensatoren 5 bis 9 an der Umladung durch wechselndes Anlegen der Referenzpotentiale ref+, ref- beteiligt.

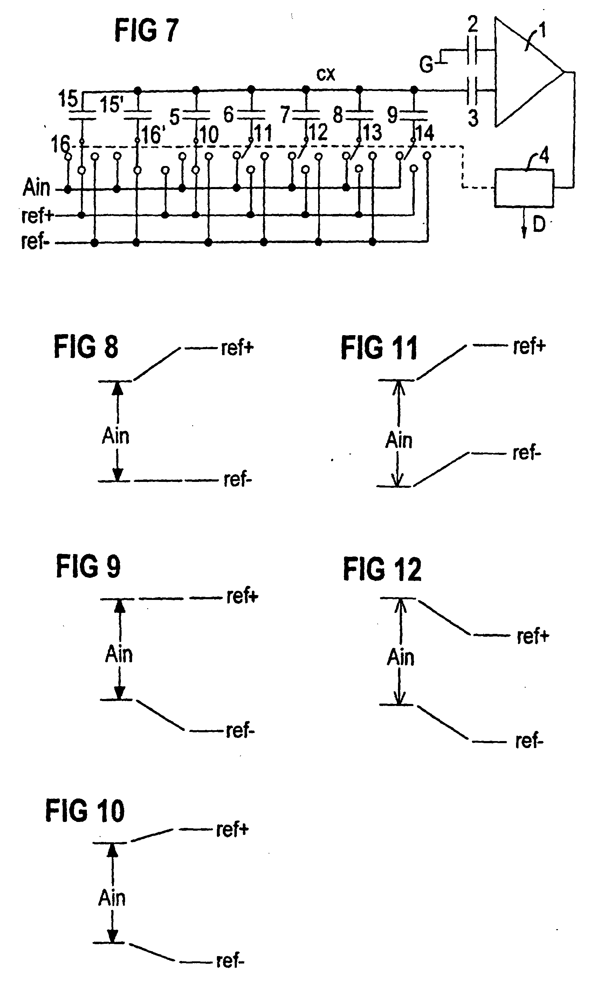

In diesen Fällen wird jedoch davon ausgegangen, daß der zulässige Bereich des Eingangspotentials größer ist als der durch die Referenzpotentiale begrenzte Bereich. Soll ein kleinerer Eingangsbereich an einen größeren Referenzbereich angepaßt werden, so wird erfindungsgemäß ein zusätzlicher Kondensator vorgesehen. Dazu ist bei dem Ausführungsbeispiel nach Figur 7 ein Kondensator 15 einerseits an den Knotenpunkt cx angeschlossen und andererseits über einen Umschalter 16 entweder auf das Referenzpotential ref+ oder das Referenzpotential ref- aufschaltbar. Während der Übernahmephase ist der Kondensator 15 auf das Eingangspotential Ain und während der Konvertierungsphase auf eines der beiden Referenzpotentiale ref+ bzw. ref- konstant aufgeschaltet. Ist der Kondensator 15 während der Konvertierungsphase mit dem Referenzpotential ref- beaufschlagt, dann wird der zulässige Eingangsbereich gegenüber dem Referenzpotential ref+ eingeschränkt, während im umgekehrten Fall -also bei konstanter Beaufschlagung des Kondensators 15 mit dem Referenzpotential ref+ während der Konvertierungsphase- der zulässige Eingangsbereich gegenüber dem Referenzpotential ref- eingeschränkt wird. Das Verhältnis des zulässigen Bereichs des Eingangspotentials Ain zu den beiden Referenzpotential ref+ und ref- ist für den ersten Fall in Figur 8 und für den zweiten Fall in Figur 9 der Zeichnung dargestellt.

Eine Einschränkung zu beiden Referenzpotentialen ref+ und ref- hin kann nun dadurch erreicht werden, daß der Kondensator 15 in zwei Teilkondensatoren 15 und 15' während bei der Konvertierungsphase aufgeteilt wird, wobei der eine Teilkondensator 15 an das Referenzpotential ref- und der andere Teilkondensator 15' an das Referenzpotential ref+ gelegt ist. Die Einschränkung des zulässigen Bereiches des Eingangspotentials Ain gegenüber den beiden Referenzpotentialen ref+ und ref- ist in Figur 10 gezeigt.

Der zulässige Bereich des Eingangspotentials Ain kann in Bezug auf den Referenzbereich verschoben werden, wenn erfindungsgemäß die zusätzliche Kapazität während der Übernahmephase auf das Referenzpotential ref+ oder ref- und in der Konvertierungsphase auf das jeweils andere Referenzpotential ref- bzw. ref+ aufgeschaltet wird. Das Verhältnis des zulässigen Bereichs des Eingangspotentials Ain zu den beiden Referenzpotentialen ref+ und ref- ist in den Figuren 11 und 12 dargestellt.

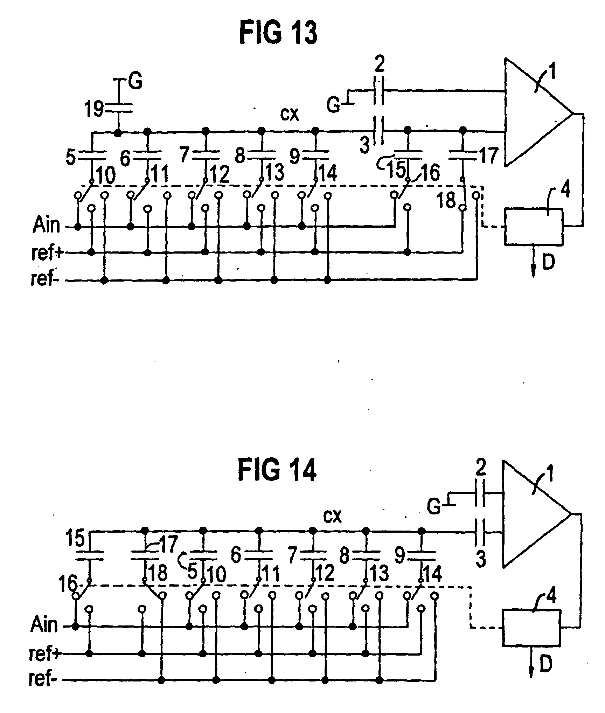

Der zusätzliche Kondensator 15 bzw. 15' hat den Nachteil, daß er wie ein zwischen den Knoten cx und das Bezugspotential G geschalteter Parasitärkondensator 19 den Spannungshub am Knoten cx vermindert. Außerdem nimmt der Kondensator 15 bzw. 15' große Kapazitätswerte an, wenn der zulässige Bereich des Eingangspotentials Ain sehr weit verschoben oder stark verkleinert werden soll. In diesem Fall kann der Kondensator 15 (15') statt am Knoten cx auch am Eingang des offsetkompensierten Komparators 1 angeschlossen werden. Die notwendige Kapazität des Kondensators 15 verringert sich dann um das Verhältnis der Kapazität des Kondensators 3 zur Summe der Kapazitäten der verbleibenden weiteren Kondensatoren. Beim Ausführungsbeispiel nach Figur 13 ist dies die Summe der Kapazitäten der Kondensatoren 5 bis 9. Der Kondensator 15 ist dabei einerseits an den anderen Eingang des Komparators 1 angeschlossen und ist andererseits über den Schalter 16 entweder auf das Eingangspotential Ain oder auf das Referenzpotential ref+ aufschaltbar. Da er zur Verkleinerung des Eingangsbereiches vorgesehen ist, wird er von der Kontrolleinrichtung 4 derart gesteuert, daß er in der Übernahmephase auf das Eingangspotential Ain und während der Konvertierungsphase auf dem Referenzpotential ref+ aufgeschaltet ist.

Daneben soll aber auch eine Verschiebung des Eingangsbereiches erfolgen. Dazu dient ein Kondensator 17, der einerseits ebenfalls an den anderen Eingang des Komparators 1 angeschlossen ist und der andererseits über einen Umschalter 18 auf jeweils eines der beiden Referenzpotentiale ref+ oder ref- während der Übernahmephase und auf das jeweils andere Referenzpotential ref- bzw. ref+ während der Konvertierungsphase aufgeschaltet ist. Da die Kondensatoren 15 und 17 direkt an den anderen Eingang des Komparators 1 angeschlossen sind, muß die Kapazität des Parasitärkondensators 19 am Knoten cx in der Berechnung berücksichtigt werden. Beim Anschluß der zusätzlichen Kondensatoren 15 und 17 am Knoten cx gemäß Figur 14 kürzt sich dagegen die Kapazität des Parasitärkondensators 19 aus der Rechnung heraus und beeinflußt daher die Genauigkeit der Bereichsverkleinerung bzw. der Bereichsverschiebung nicht.

Um bei dem Ausführungsbeispiel nach Figur 14 einen zulässigen Bereich des Eingangspotentials Ain von 1,6 Volt bis 3,4 Volt zu erzielen, muß bei einer Referenzspannung ref+ von 2,8 Volt und ref- von 0 Volt die Kapazität des Kondensators 15 das 0,5555-fache der Gesamtkapazität des Netzwerkes sein und in der Übernahmephase auf das Eingangspotential Ain aufgeschaltet werden. Die Kapazität des Kondensators 17 muß gleich dem 0,3333-fachen der Gesamtkapazität des Kapazitätsnetzwerkes sein und in der Übernahmephase auf das Referenzpotential refaufgeschaltet werden. Beide Kondensatoren 15 und 17 sind während der Konvertierungsphase mit dem Referenzpotential ref+ beaufschlagt. Die Gesamtkapazität ist gleich der Summe der Kapazitäten der Kondensatoren 5 bis 9. Die Kapazitäten der Kondensatoren 5 bis 9 sind bevorzugt untereinander binär gewichtet.

**Patentansprüche**

1.   Analog-Digitalumsetzer mit Eingangsspannungsbereich, der nicht durch die Referenzspannungen festgelegt ist, zur Umwandlung eines anlogen Eingangssignals ($A_{in}$) in ein digitales Ausgangssignal (D), wobei der Analog-Digitalumsetzer aufweist:

einen Komparator (1) mit einem ersten und zweiten Eingang sowie einem Ausgang, der mit einer Kontrolleinrichtung (4) zur Steuerung steuerbarer Umschalter (10-14, 16, 18) verbunden ist,

einen Kondensator (2), der zwischen einem Bezugspotential (G) und dem ersten Eingang des Komparators (1) geschaltet ist,

ein Kopplungsbauelement (3), das zwischen einem Knotenpunkt (cx) und dem zweiten Eingang des Komparators (1) geschaltet ist,

mehrere Kondensatoren (5-9), die jeweils über einen ersten Anschluss mit dem Knotenpunkt (cx) verbunden sind und mit einem zweiten Anschluss über einen zugehörigen steuerbaren Umschalter (10-14) auf ein Eingangsspannungspotential ($A_{in}$) des analogen Eingangssignals, auf ein erstes Referenzpotential (ref +) oder auf ein zweites Referenzpotential (ref -) geschaltet sind,

wobei während einer Übernahmephase zur EingangsspannungsBereichserweiterung zumindest ein Teil (5, 6) der Kondensatoren (5-9) entweder auf das erste Referenzpotential (ref +) oder auf das und der verbleibende Teil der Kondensatoren (7-9) auf das Eingangsspannungspotential ($A_{in}$) geschaltet sind,

wobei während einer Konvertierungsphase mindestens ein Teil der Kondensatoren (5-9) über den zugehörigen Umschalter (10-14) wechselnd auf die Referenzpotentiale (ref +, ref -) zur Ladungsumverteilung geschaltet sind,

**dadurch gekennzeichnet,**
**dass** ein erster zusätzlicher Kondensator (15) vorgesehen ist, der über einen ersten Anschluss mit dem Knotenpunkt (cx) verbunden ist und mit einem zweiten Anschluss über einen zugehörigen steuerbaren Umschalter (16) während der Übernahmephase auf das Eingangsspannungspotential ($A_{in}$) und während der Konvertierungsphase auf eines der beiden Referenzpotentiale (ref +, ref -) zur Eingangsspannungs-Bereichseinschränkung geschaltet ist.

2. Analog-Digitalumsetzer nach Anspruch 1,
   **dadurch gekennzeichnet,**
   **dass** ein zweiter zusätzlicher Kondensator (17) vorgesehen ist, der über einen ersten Anschluss mit dem Knotenpunkt (cx) verbunden ist und mit einem zweiten Anschluss über einen zugehörigen steuerbaren Umschalter (18) während der Übernahmephase auf eines der beiden Referenzpotentiale (ref +, ref -) und während der Konvertierungsphase auf das jeweils andere Referenzpotential der beiden Referenzpotentiale (ref -, ref +) zur Eingangsspannungs-Bereichsverschiebung geschaltet ist.

3. Analog-Digitalumsetzer nach Anspruch 1 oder 2,
   **dadurch gekennzeichnet,**
   **dass** die Kapazitäten der Kondensatoren (5-9) binär zueinander gewichtet sind.

4. Analog-Digitalumsetzer nach einem der vorangehenden Ansprüche,
   **dadurch gekennzeichnet,**
   **dass** das Kopplungsbauelement (3) ein Kondensator ist.

5. Analog-Digitalumsetzer nach einem der vorangehenden Ansprüche 1-3,
   **dadurch gekennzeichnet,**
   **dass** das Kopplungsbauelement (3) eine Drahtverbindung ist.

**Claims**

1. Analogue/digital converter having an input voltage range, which is not defined by the reference voltages, for conversion of an analogue input signal ($A_{in}$) to a digital output signal (D), with the analogue/digital converter having:

   a comparator (1) with a first and a second input as well as an output which is connected to a monitoring device (4) for controlling controllable changeover switches (10-14, 16, 18),
   a capacitor (2) which is connected between a reference-earth potential (G) and the first input of the comparator (1),
   a coupling component (3) which is connected between a node point (cx) and the second input of the comparator (1),
   a number of capacitors (5-9) which are each connected via a first connection to the node point (cx) and are connected by a second connection and via an associated controllable changeover switch (10-14) to an input voltage potential ($A_{in}$) of the analogue input signal, to a first reference potential (ref +), or to a second reference potential (ref -),

with, during an acceptance phase for input voltage range expansion, at least some (5, 6) of the capacitors (5-9) are connected either to the first reference potential (ref +) or to the [lacuna], and the remainder of the capacitors (7-9) are connected to the input voltage potential ($A_{in}$),

with, during a conversion phase, at least some of the capacitors (5-9) being connected via the associated changeover switch (10-14) alternately to the reference potentials (ref +, ref -) for charge redistribution,

**characterized**

**in that** a first additional capacitor (15) is provided, which is connected via a first connection to the node point (cx) and is connected to a second connection via an associated controllable changeover switch (16) to the input voltage potential ($A_{in}$) during the acceptance phase and to one of the two reference potentials (ref +, ref -) during the conversion phase, in order to restrict the input voltage range.

2. Analogue/digital converter according to Claim 1,
   **characterized**
   **in that** a second additional capacitor (17) is provided, which is connected via a first connection to the node point (cx) and is connected by a second connection via an associated controllable changeover switch (18) to one of the two reference potentials (ref +, ref -) during the acceptance phase and to the respective other reference potential of the two reference potentials (ref -, ref +) during the conversion phase, in order to shift the input voltage range.

3. Analogue/digital converter according to Claim 1 or 2,
   **characterized**
   **in that** the capacitances of the capacitors (5-9) are weighted in a binary form with respect to one another.

4. Analogue/digital converter according to one of the preceding claims,
   **characterized**
   **in that** the coupling component (3) is a capacitor.

5. Analogue/digital converter according to one of the preceding Claims 1-3,
   **characterized**
   **in that** the coupling component (3) is a wire link.

**Revendications**

1. Convertisseur analogique-numérique à plage de tension d'entrée qui n'est pas fixée par les tensions de référence, destiné à convertir un signal d'entrée analogique ($A_{in}$) en un signal de sortie numérique (D), le convertisseur analogique-numérique comportant :

   un comparateur (1) ayant une première entrée et une deuxième entrée ainsi qu'une sortie qui est reliée à un dispositif de commande (4) pour la commande de commutateurs (10 à 14, 16, 18) qui peuvent être commandés,
   un condensateur (2) qui est branché entre un potentiel de référence (G) et la première entrée du comparateur (1),
   un élément de couplage (3) qui est branché entre un noeud (cx) et la deuxième entrée du comparateur (1),
   plusieurs condensateurs (5 à 9) qui sont reliés à chaque fois par une première borne au noeud (cx) et qui sont branchés par une deuxième borne par l'intermédiaire d'un commutateur pouvant être commandé associé (10 à 14) sur un potentiel de tension d'entrée ($A_{in}$) du signal d'entrée analogique, sur un premier potentiel de référence (ref +) ou sur un deuxième potentiel de référence (ref -),
   dans lequel, pendant une phase de transfert, pour l'extension de la plage de tension d'entrée, au moins une partie (5, 6) des condensateurs (5 à 9) est branchée soit sur le premier potentiel de référence (ref +) soit sur le deuxième potentiel de référence (ref -) et la partie restante (7 à 9) des condensateurs est branchée sur le potentiel de tension d'entrée ($A_{in}$),
   dans lequel, pendant une phase de conversion, au moins une partie des condensateurs (5 à 9) est branchée par l'intermédiaire des commutateurs associés (10 à 14) en alternance sur les potentiels de référence (ref +, ref -) pour la redistribution de charge,

**caractérisé par** le fait qu'il est prévu un premier condensateur supplémentaire (15) qui est relié par une première borne au noeud (cx) et qui est branché par une deuxième borne par l'intermédiaire d'un commutateur pouvant être commandé associé (16) pendant la phase de transfert sur le potentiel de tension d'entrée ($A_{in}$) et pendant la phase de conversion sur l'un des deux potentiels de référence (ref +, ref -) en vue d'une restriction de la plage de tension d'entrée.

2. Convertisseur analogique-numérique selon la revendication 1,
**caractérisé par** le fait qu'il est prévu un deuxième condensateur supplémentaire (17) qui est relié par une première borne au noeud (cx) et qui est branché par une deuxième borne par l'intermédiaire d'un commutateur pouvant être commandé associé (18) pendant la phase de transfert sur l'un des deux potentiels de référence (ref +, ref -) et pendant la phase de conversion sur l'autre potentiel de référence respectif des deux potentiels de référence (ref -, ref +) en vue d'un décalage de la plage de tension d'entrée.

3. Convertisseur analogique-numérique selon la revendication 1 ou 2,
**caractérisé par** le fait que les capacités des condensateurs (5 à 9) sont pondérées de façon binaire les unes par rapport aux autres.

4. Convertisseur analogique-numérique selon l'une des revendications précédentes,
**caractérisé par** le fait que l'élément de couplage (3) est un condensateur.

5. Convertisseur analogique-numérique selon l'une des revendications précédentes 1 à 3,
**caractérisé par** le fait que l'élément de couplage (3) est une liaison par fil.

## FIG 1

## FIG 2

## FIG 4

# FIG 3

# FIG 5

# FIG 6

FIG 7

FIG 8

FIG 9

FIG 10

FIG 11

FIG 12

# FIG 13

# FIG 14